(19) Europäisches Patentamt
European Patent Office
Office européen des brevets

(11) **EP 1 797 479 B1**

(12) **FASCICULE DE BREVET EUROPEEN**

(45) Date de publication et mention
de la délivrance du brevet:
**13.06.2012 Bulletin 2012/24**

(21) Numéro de dépôt: **05802693.1**

(22) Date de dépôt: **29.09.2005**

(51) Int Cl.:
*G03F 7/00* (2006.01)        *B81C 1/00* (2006.01)
*H05K 3/40* (2006.01)

(86) Numéro de dépôt international:
**PCT/FR2005/050794**

(87) Numéro de publication internationale:
**WO 2006/054004 (26.05.2006 Gazette 2006/21)**

(54) **DISPOSITIF OBTENU PAR NANOIMPRESSION COMPORTANT DES MOTIFS METALLIQUES ET PROCEDE DE NANOIMPRESSION DE MOTIFS METALLIQUES**

DURCH NANODRUCK ERHALTENE VORRICHTUNG MIT METALLISCHEN MUSTERN UND NANODRUCKVERFAHREN VON METALLISCHEN MUSTERN

DEVICE OBTAINED BY NANOPRINTING COMPRISING METALLIC PATTERNS AND METHOD FOR NANOPRINTING OF METALLIC PATTERNS

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **04.10.2004 FR 0452250**

(43) Date de publication de la demande:
**20.06.2007 Bulletin 2007/25**

(73) Titulaire: **Commissariat à l'Énergie Atomique et aux Énergies Alternatives**
**75015 Paris (FR)**

(72) Inventeurs:
• **MARION, François**
**F-38950 SAINT-MARTIN-DE-VINOUX (FR)**
• **DAVOINE, Cécile**
**F-76620 LE HAVRE (FR)**

(74) Mandataire: **Poulin, Gérard et al**
**BREVALEX**
**95, rue d'Amsterdam**
**75378 Paris Cedex 8 (FR)**

(56) Documents cités:
**WO-A-99/64642        WO-A-2004/114017**
**US-A- 5 259 926        US-A- 5 772 905**

• **CHOU S Y ET AL: "IMPRINT LITHOGRAPHY WITH 25-NANOMETER RESOLUTION" SCIENCE, AMERICAN ASSOCIATION FOR THE ADVANCEMENT OF SCIENCE,, US, vol. 272, 5 avril 1996 (1996-04-05), pages 85-87, XP000602257 ISSN: 0036-8075**
• **PATENT ABSTRACTS OF JAPAN vol. 2003, no. 12, 5 décembre 2003 (2003-12-05) & JP 2004 319762 A (CANON INC), 11 novembre 2004 (2004-11-11)**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

**DOMAINE TECHNIQUE**

L'invention concerne un dispositif nanoimprimé comportant des motifs métalliques et un procédé de nanoimpression de motifs métalliques.

Le domaine technique auquel se rapporte l'invention est celui de la microélectronique et plus spécifiquement de la fabrication de nanostructures en métal ou alliages de métaux.

L'invention peut être appliquée à toutes sortes de dispositifs nécessitant la fabrication de motifs métalliques à très petit pas, par exemple de couches intermédiaires de nanopointes permettant l'interconnexion de plusieurs composants électroniques à des pas réduits.

**ÉTAT DE LA TECHNIQUE ANTÉRIEURE**

La nanoimpression est une technique permettant la fabrication de motifs à des pas très réduits, c'est-à-dire des motifs de quelques nanomètres répétés à un pas de quelques nanomètres.

La nanoimpression sur des motifs polymériques permet la réalisation de masques. Le document référencé [1] en fin de description décrit, ainsi, un procédé lithographique pour créer des motifs ultra-fins (inférieurs à 25nm) dans un film fin déposé sur un substrat, dans lequel un moule ayant au moins une caractéristique en saillie est pressé dans ce film. Mais, il est alors difficile de réaliser des nanomotifs métalliques de forme acérée ou complexe, telle que celle qui est nécessaire pour percer une couche d'oxyde comme décrit dans le document référencé [2]. Ce document décrit, ainsi, un procédé de connexion par insertion entre une première pièce munie de micropointes conductrices dures et une seconde pièce munie de plots surmontés par des micro-billes conductrices ductiles, dans lequel chaque micro-pointe doit percer le croûte d'oxyde natif en surface d'une micro-bille. En effet les techniques de gravure et de « lift off » reproduisent des motifs plats de par la nature des techniques de photolithographie employées après nanoimpression des résines.

Si l'on supprime cette étape de nanoimpression des résines on peut alors réaliser une impression directe dans le métal de motifs en forme de pointe, ou autre forme complexe, grâce à un moule dur. Une telle technique d'impression directe dans le métal est décrite dans le document référencé [3]. Ce document décrit, ainsi, la nanoimpression de motifs dans un substrat en aluminium en utilisant un moule dur en SiC.

Mais lorsque l'on veut réaliser de tels motifs métalliques deux problèmes peuvent se présenter suivant les applications visées :

1) Des pressions extrêmes de nanoimpression sont nécessaires : le procédé proposé dans le document référencé [3] nécessite la mise en oeuvre d'une pression de moulage très importante : 2,38T par cm$^2$. Ce procédé ne peut donc pas être employé sur une couche mince métallique déposée sur un matériau fragile, par exemple semi-conducteur, sans risquer d'entraîner une rupture.

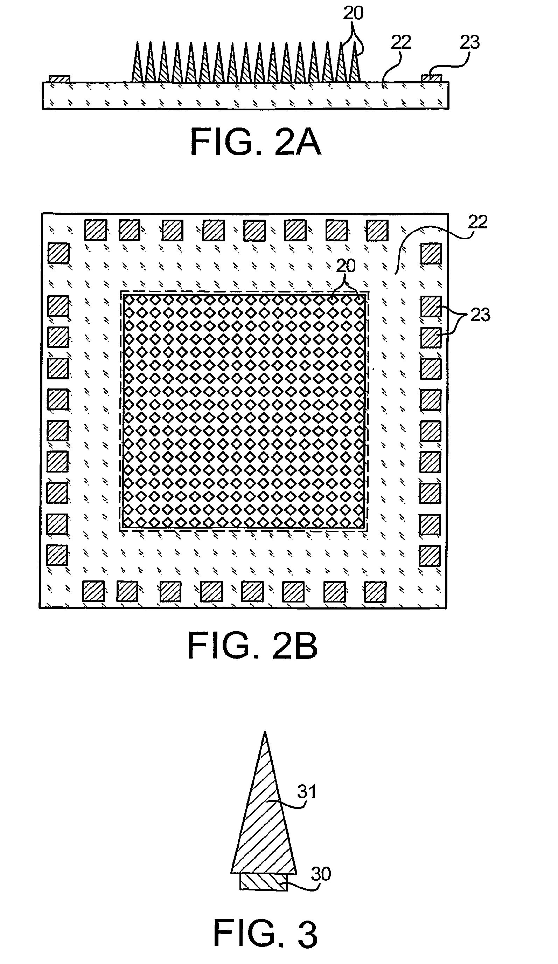

2) Les plots de microcâblage (« wire-bonding ») doivent être dégagés : dans le cas d'une application de ce procédé à une tranche de semi-conducteur issue d'une fonderie silicium, il est nécessaire de dégager des zones sans métal autour d'une puce comportant, comme illustré sur la figure 2B, un ensemble de pointes 20 et des plots de microcâblage 23.

En outre, après nanoimpression de motifs sur les surfaces voulues il est nécessaire de procéder à une gravure des reliquats de matériau imprimé pour les retirer des zones où ils ne sont pas désirés.

Dans le cas d'un procédé de connexion par insertion, il s'agit d'imprimer des pointes puis de supprimer la couche de métal résiduelle écrasée en film fin dans les zones des plots de microcâblage de manière à permettre l'accès à ces plots par les fils de microcâblage. Mais ces plots, qui sont le plus souvent en aluminium, risquent alors d'être aussi attaqués.

La figure 1A illustre ainsi un moulage de métal sous forte pression P. Un moule 11 permet ainsi d'obtenir, à la surface d'un substrat 12, une couche métallique moulée 13 formant un ensemble de pointes 14, une couche métallique résiduelle 15 restant à la surface de ce substrat.

La figure 1B illustre la gravure 17 du métal résiduel. Cette attaque pose, donc, le problème de l'attaque des plots de microcâblage 16 en aluminium.

Les figures 2A et 2B illustrent un exemple de réalisation, dans lequel on désire imprimer des pointes métalliques 20 en aluminium dans une zone centrale 21 de puces couvrant une grande plaque de circuit CMOS, et ne rien imprimer dans la zone extérieure 22 présentant des plots métalliques en aluminium 23 permettant un microcâblage ultérieur.

La gravure des résiduels d'aluminium présents entre les pointes 20 après impression vient directement attaquer les plots de microcâblage 23 également en aluminium situés dans la zone extérieure 22, empêchant leur exploitation ultérieure.

L'invention a pour effet d'apporter une solution à ces problèmes de réalisation de nano-motifs métalliques.

## EXPOSÉ DE L'INVENTION

L'invention concerne un dispositif nanoimprimé comportant des motifs métalliques en forme de pointe, caractérisé en ce que chaque motif métallique a une structure bicouche métallique contrôlée en dureté et en propriétés chimiques comprenant une couche inférieure constituant la base de la pointe et une couche supérieure constituant la pointe elle-même. L'invention est definie dans les revendications.

Avantageusement le matériau de la couche inférieure est un matériau présentant une température de fusion T1 supérieure à T2 + 200°C, T2 étant la température de fusion de la couche supérieure, et une dureté supérieure à 10 GPa. Le matériau de la couche supérieure est un métal à point de fusion T2 proche de la température d'impression Timp. On peut ainsi avoir la relation :

$$2/3 \times T2 < Timp < 2/3 \times T1.$$

Avantageusement le matériau de la couche supérieure est attaquable chimiquement par des produits qui n'attaquent pas le matériau de la couche inférieure.

L'invention selon la revendication 6 concerne également un procédé de nanoimpression de motifs métalliques à la surface d'un substrat, caractérisé en ce qu'il comprend les étapes suivantes :

- une étape de dépôt d'une couche inférieure en métal sur ce substrat,
- une étape de dépôt d'une couche supérieure en métal,
- une étape de moulage de la couche supérieure,
- une étape de gravure de la couche supérieure en s'arrêtant sur la couche inférieure,
- une étape de gravure de la couche inférieure.

L'étape de moulage peut être une étape de moulage par indexation, ou une étape de moulage globale. Dans les deux cas pendant l'étape de moulage :

- on chauffe le substrat et le moule à une température telle que : 186°C<Timp<1112°C, pour une couche supérieure en AuSn,
- on applique un moule sur la surface à imprimer,
- on retire le moule.

Avantageusement ce procédé comporte, en outre, une étape de gravure après l'étape de dépôt de la couche supérieure en métal.

L'invention permet d'imprimer des nanomotifs par impression directe dans un métal avec :

- une mise en oeuvre d'une pression d'impression faible,
- une mise en oeuvre aisée de la gravure du métal résiduel.

L'invention permet la fabrication de composants électroniques hybridés lorsqu'elle est associée à des techniques d'assemblage.

L'invention peut être utilisée notamment :

- dans la fabrication de matrices de détection infrarouge de grande taille, de matrices hybridées à très petit pas à froid,
- dans la fabrication de composants hybridés à froid de toutes natures (optique, X, hybridation sur support flexible, sur céramique, ou de modules multipuces (MCM : « multichip module »),
- dans le traitement pour la préparation à l'hybridation par impression sans photolithographie de composants de très grande taille (par exemple pour équiper de pointes des tranches CMOS de 300mm, pour préparer de substrats verres pour un report de circuits sur écrans plats, pour imprimer des guides d'ondes en verre sur une sous-couche dure.......)

## BRÈVE DESCRIPTION DES DESSINS

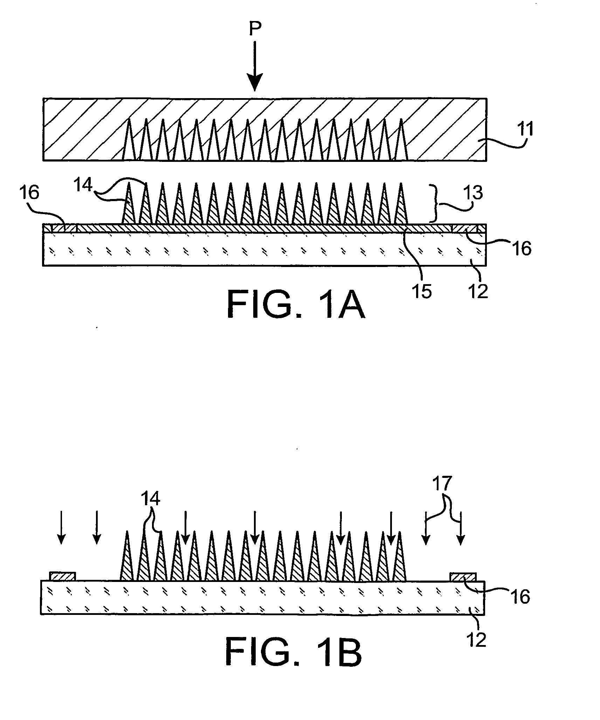

Les figures 1A et 1B illustrent un procédé de l'art connu.
Les figures 2A et 2B illustrent la fabrication de micropointes sur une tranche CMOS, en utilisant un procédé de l'art connu.
La figure 3 illustre un motif métallique du dispositif de l'invention.

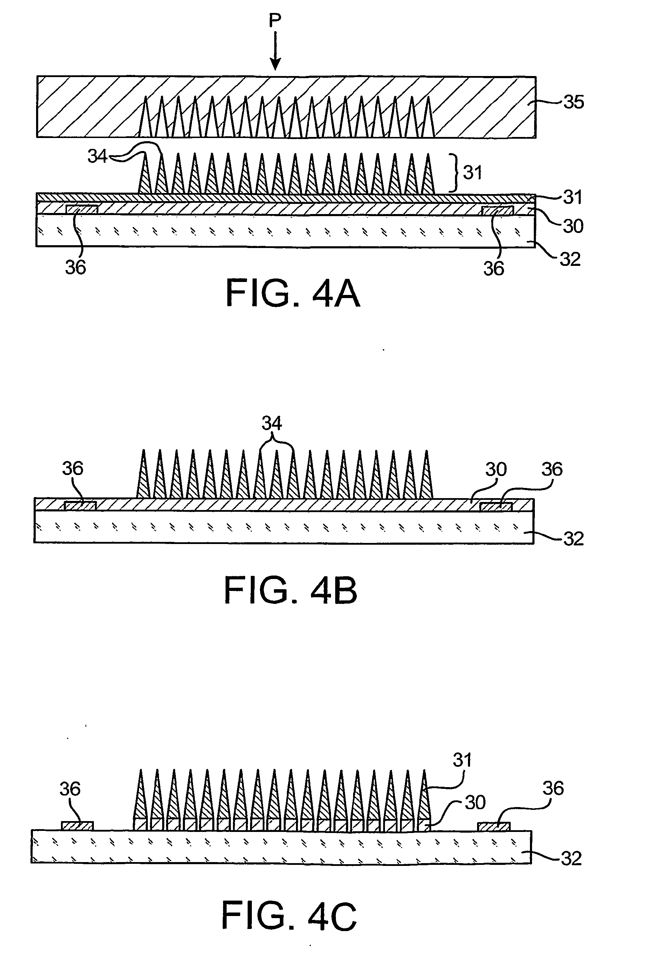

Les figure 4A, 4B et 4C illustrent les étapes du procédé de l'invention.

## EXPOSÉ DÉTAILLÉ DE MODE DE RÉALISATION PARTICULIERS

Comme illustré sur la figure 3, la structure d'un motif métallique du dispositif nanoimprimé de l'invention est une structure bicouche métallique en forme de pointe contrôlée en dureté et en propriétés chimiques comportant une couche inférieure 30 constituant la base de la pointe, et une couche supérieure 31 constituant la pointe elle-même.

Le matériau de la couche inférieure 30 est un matériau présentant une température de fusion T1 supérieure à T2 + 200°C, T2 étant la température de fusion de la couche supérieure, et une dureté supérieure à 10 GPa.

Le matériau de la couche supérieure 31 est un métal à point de fusion T2 proche de la température d'impression Timp.

Les deux matériaux de ces couches 30 et 31 satisfont à un deuxième critère lié aux chimies d'attaques qui leur sont propres. Le matériau de la couche supérieure 31 est attaquable chimiquement par des produits qui n'attaquent pas le matériau de la couche inférieure 30.

Avantageusement on peut réduire la pression de nanoimpression en utilisant une température d'impression Timp supérieure à 2/3 de la température de fusion T2. La dureté du métal est ainsi réduite et les pressions nécessaires également. On peut ainsi avoir la relation : 2/3 X T2<Timp<2/3 X T1.

Pendant la nanoimpression, le métal de la couche inférieure 30, de grande dureté à la pression d'impression, protége les couches fragiles sous jacentes d'éventuelles pression locales dues à des poussières, aspérités, etc...situées entre presse et substrat.

Après nanoimpression on supprime les problèmes d'attaque des résiduels en choisissant un couple de métaux de telle manière qu'il existe une chimie d'attaque de la couche supérieure sélective par rapport à la couche inférieure. Dans un premier temps on vient donc attaquer la couche supérieure 31 en s'arrêtant sur la couche inférieure 30, les plots 36 présents en surface du substrat 32 étant protégés par la couche inférieure. L'attaque du métal de la couche inférieure 30 lors d'une étape de gravure sélective ultérieure permet de ne supprimer la couche inférieure que dans les zones non imprimées.

### Exemple de mise en ouvre du procédé de l'invention

Cet exemple, illustré par les figures 4A à 4C, est appliqué à une tranche CMOS issu d'une fonderie silicium, telle qu'illustrée sur figures 2A et 2B. Il comporte les étapes suivantes :

### 1) dépôt de la couche inférieure 30

Un dépôt de Ti (T1=1667°C), est effectué dans une machine de pulvérisation standard sur le substrat 32 à équiper de pointes, par exemple un substrat CMOS issu d'une fonderie 300 mm.

### 2) dépôt de la couche supérieure 31

Un dépôt de Au80Sn20 ($4\mu$m) est effectué dans une machine de dépôt standard (évaporation, pulvérisation, électrolyse...). La température de fusion de cet eutectique est de 280°C.

### 3) Définition de la couche supérieure 31

Cette étape est optionnelle. Elle permet de dissocier le retrait des couches résiduelles.

Pendant cette étape un retrait est réalisé sur les plots fondeurs avant impression et entre les plots microcâblage nanoimprimés après impression. Cette étape facilite grandement le procédé global. En effet, si le matériau formant les pointes est formé uniquement dans les zones où il est utile, il n'est plus nécessaire de le presser dans les zones 22. Comme la pression ne s'exerce alors que dans les zones 21, elle est sensiblement réduite.

On peut soit réaliser un masquage KI pour réaliser cette gravure, soit déposer le matériau 31 par procédé « lift off » (dépôt sélectif de résine avant le dépôt du matériau). On réalise un masquage à faible coût (pas de résolution demandée sur des grands carrés) et on grave la couche supérieure 31 dans la zone 22 illustrée sur la figure 2B, en s'arrêtant sur la couche inférieure 30. Dans les deux cas, le matériau 30 est déposé en fond continu sur la plaque pour assurer son rôle de protection.

### 4) Moulage de la couche supérieure 31

L'opération de moulage de cette couche 31 est réalisée suivant:

- soit une technique de moulage par « indexation » (un moule 35 de la taille d'un champ de photocomposition est appliqué sur chaque champ et indexé au pas du champ (« step an repeat »))
- soit une technique de moulage « globale » le moule 35 est de la même taille que la plaque (300mm) et le moulage est réalisé en un seule opération.

Dans les deux cas :

- On chauffe le substrat 32 et le moule 35 à une température : 2/3x T2<Timp<2/3 T1 soit 186°C<Timp<1112°C, pour une couche supérieure en AuSn,
- On applique le moule 35 sur la surface à imprimer avec une pression P. Les pointes sont imprimées de manière traditionnelle. La couche inférieure 30 protège la surface du substrat 32 et ne se déforme pas,
- On retire le moule 35.

### 5) Gravure de la couche supérieure résiduelle

A l'issue de l'étape précédente il demeure, entre les pointes un résiduel de couche supérieure 31 sur la couche inférieure 30 inaltérée. Si les motifs imprimés ont, par exemple, une hauteur finale de $6\mu m$ et le couche résiduelle a une épaisseur de $0,2\mu m$, on réalise une gravure uniforme correspondant par exemple à un retrait de $0,3\mu m$ de couche supérieure sur l'entière surface de celle-ci par des moyens chimiques. La chimie utilisée, étant sélective, s'arrête automatiquement sur la couche inférieure.

La couche supérieure résiduelle est ainsi dégagée entre les pointes 31. Cette étape n'est pas critique du fait que la couche inférieure 30 forme alors une couche d'arrêt.

La zone 22 est exposée à cette gravure, et les plots de microcâblage 36 sont protégés par la couche inférieure 30. Du fait de cette gravure globale, la pointe perd uniformément une épaisseur de $0,3\mu m$ sur toute son enveloppe extérieure. Les dimensions du moule 35 tiennent donc compte de cette perte.

### 6) Gravure de la couche inférieure 30

Le métal de la couche inférieure 30 est gravé par une chimie propre sélective : par exemple une chimie à base de H2O2 (couche inférieure en titane) ou un plasma fluoré.

La couche inférieure est gravée simultanément dans les zones 21 et 22.

Les pointes finales 34 peuvent être par exemple des pointes de $6\mu M$ de haut, de diamètre à la base de $1\mu m$, répétées à un pas de $2\mu m$. Pour la couche supérieure 31 on utilise généralement des binaires à bas point de fusion mais des métaux purs peuvent convenir ainsi que tout alliage ternaire (ou+). Une nanoimpression de verres peut également être envisagée.

On peut ainsi avoir le tableau suivant :

| Couche supérieure | Température de fusion (°C) | Chimie | Epaisseur suggérée |
|---|---|---|---|
| Au80Sn20 | 280 | à base de KI | 1 $20\mu m$ |
| Au97Si3 | 363 | KI- | - |
| Au88Ge12 | 361 | KI- | - |
| Sn5Pb95 | 315 | à base d'Acide Hcl,HnO3 | - |
| Sn62Pb38 | 183 | - | - |
| Sn | 232 | - | - |
| AgCuSn | 210 | - | |

(suite)

| Couche supérieure | Température de fusion (°C) | Chimie | Epaisseur suggérée |
|---|---|---|---|
| | | | |
| Couche inférieure | Température de fusion | Chimie | Epaisseur suggérée |
| Pd | 1554 | Hn03 | 0,1-2$\mu$m |
| Pt | 1768 | Hot HCl | - |
| Ni | 1455 | FeCl3 | - |
| Ti | 1667 | H2O2 | - |
| TiW,TiN,etc | >1200 | H2O2 | - |
| Cr | 1860 | Base Perchlorique or nitrique | or - |

Un ratio d'épaisseur de 10 pour 1 est intéressant entre la couche supérieure et la couche inférieure. Le pas d'impression diminue avec les épaisseurs.

**REFERENCES**

[1] US 5, 772, 905

[2] US 6, 179, 198

[3] Article intitulé « Direct nano-printing on Al substrate using a SiC mold » de S. W. Pang, T. Tamamura, M. Nakao, A. Ozawa et H. Masuda (J. Vac. Sci. Technol, B 16(3), mai/juin 1998, pages 1145 et 1146).

**Revendications**

1. Dispositif nanoimprimé comportant des nanomotifs métalliques en forme de pointe, **caractérisé en ce que** chaque nanomotif métallique a une structure bicouche contrôlée en dureté et en propriété chimique comprenant une couche inférieure (30) en métal constituant la base de la pointe et une couche supérieure (31) en métal constituant la pointe elle-même.

2. Dispositif selon la revendication 1, dans lequel le matériau de la couche inférieure est un matériau présentant une température de fusion T1 supérieure à T2 + 200°C, T2 étant la température de fusion de la couche supérieure, et une dureté supérieure à 10 GPa.

3. Dispositif selon la revendication 2, dans lequel le matériau de la couche supérieure est un métal à point de fusion T2 proche de la température d'impression Timp.

4. Dispositif selon la revendication 3 dans lequel on a la relation :

$$2/3 \times T2 < Timp < 2/3 \times T1.$$

5. Dispositif selon la revendication 1, dans lequel le matériau de la couche supérieure (31) est attaquable chimiquement par des produits qui n'attaquent pas le matériau de la couche inférieure (30).

6. Procédé de nanoimpression de motifs métalliques à la surface d'un substrat (32) pour réaliser des dispositifs imprimés conformément à l'une quelconque des revendications 1 à 5, **caractérisé en ce qu'**il comprend les étapes suivantes :

    - une étape de dépôt d'un couche inférieure en métal (30) sur ce substrat (32),
    - une étape de dépôt d'une couche supérieure en métal (31),

- une étape de moulage de la couche supérieure,
- une étape de gravure de la couche supérieure (31) en s'arrêtant sur la couche inférieure (30),
- une étape de gravure de la couche inférieure (30).

**7.** Procédé selon la revendication 6, dans lequel l'étape de moulage est une étape de moulage par indexation.

**8.** Procédé selon la revendication 6, dans lequel l'étape de moulage est une étape de moulage globale.

**9.** Procédé selon la revendication 6, dans lequel pendant l'étape de moulage :

- on chauffe le substrat (32) et le moule (35) à une température telle que : 186°C<Timp<1112°C pour une couche supérieure en AuSn,
- on applique un moule (35) sur la surface à imprimer,
- on retire un moule (35).

**10.** Procédé selon la revendication 6 qui comporte, en outre, une étape de gravure après l'étape de dépôt de la couche supérieure.

**Claims**

**1.** Nanoprinted device comprising point shaped nanometaliic patterns, **characterised in that** each nanometallic pattern has a bilayer structure controlled in hardness and in chemical properties comprising a lower layer in metal (30) constituting the base of the point and an upper layer in metal (31) constituting the point itself.

**2.** Device according to claim 1, in which the material of the lower layer is a material with a melting temperature T1 greater than T2 + 200°C, T2 being the melting temperature of the upper layer, and a hardness greater than 10 GPa.

**3.** Device according to claim 2, in which the material of the upper layer is a metal with a melting point T2 similar to the printing temperature Tprint.

**4.** Device according to claim 3 in which one has the reflation:

$$2/3 \text{ x } T2 < Tprint < 2/3 \text{ x } T1.$$

**5.** Device according to claim 1, in which the material of the upper layer (31) may be chemically attached by products that do not attack the material of the lower layer (30).

**6.** Method of nanoprinting metallic patterns on the surface of a substrate (32) to realize nanoprinted devices according to any one of claims 1 to 5, **characterised in that** it comprises the following steps:

- a step of deposition of a lower layer in metal (30) on this substrate (32),
- a step of deposition of an upper layer in metal (31),
- a step of molding of the upper layer,
- a step of etching of the upper layer (31) stopping on the lower layer (30),
- a step of etching of the lower layer (30).

**7.** Method according to claim 6, in which the step of moulding is a step of indexing moulding.

**8.** Method according to claim 6, in which the step of moulding is a step of overall moulding.

**9.** Method according to claim 6, in which during the step of moulding:

- one heats the substrate (32) and the mould (35) to a temperature such that: 186°C<Tprint<1112°C for an upper layer in AuSn,
- one applies a mould (35) to the surface to be printed,

- one removes a mould (35).

**10.** Method according to claim 6 that further comprises a step of etching after the step of deposition of the upper layer.

**Patentansprüche**

**1.** Nanobedruckte Vorrichtung, umfassend metallische Nanomuster in Form von Spitzen, **dadurch gekennzeichnet, dass** jedes metallische Nanomuster eine zweischichtige Struktur aufweist, die bezüglich Härte/Festigkeit und chemischer Eigenschaft kontrolliert ist, umfassend eine untere Schicht (30) aus Metall, welche die Basis der Spitze bildet, und eine obere Schicht (31) aus Metall, welche die Spitze selbst bildet.

**2.** Vorrichtung nach Anspruch 1, wobei das Material der unteren Schicht ein Material ist, welches eine Schmelztemperatur T1 aufweist, die größer als T2 + 200 °C ist, wobei T2 die Schmelztemperatur der oberen Schicht ist, und eine Härte/Festigkeit von mehr als 10 GPa aufweist.

**3.** Vorrichtung nach Anspruch 2, wobei das Material der oberen Schicht ein Metall mit Schmelzpunkt T2 nahe an der Bedruckungs-Temperatur Timp ist.

**4.** Vorrichtung nach Anspruch 3, wobei die Beziehung

$$2/3 \times T2 < Timp < 2/3 \times T1$$

gilt.

**5.** Vorrichtung nach Anspruch 1, wobei das Material der oberen Schicht (31) chemisch von Produkten angreifbar ist, die das Material der unteren Schicht (30) nicht angreifen.

**6.** Verfahren zum Nanodrucken von metallischen Mustern auf die Oberfläche von einem Substrat (32), um bedruckte Verrichtungen nach einem der Ansprüche 1 bis 5 zu bilden, **dadurch gekennzeichnet, dass** es die folgenden Schritte umfasst:

- einen Schritt des Aufbringens einer unteren Schicht aus Metall (30) auf das Substrat (32),
- einen Schritt des Aufbringens einer oberen Schicht aus Metall (31),
- einen Schritt des Formens der oberen Schicht,
- einen Schritt des Ätzens der oberen Schicht (31) wobei auf der unteren Schicht (30) angehalten wird,
- einen Schritt des Ätzens der unteren Schicht (30).

**7.** Verfahren nach Anspruch 6, wobei der Schritt des Formens ein Schritt des abschnittsweisen Formens ist.

**8.** Verfahren nach Anspruch 6, wobei der Schritt des Formens ein Schritt des globalen Formens ist.

**9.** Verfahren nach Anspruch 6, wobei während des Schritts des Formens:

- das Substrat (32) und die Form (35) auf eine Temperatur erhitzt werden, so dass: 186 °C < Timp < 1112 °C für eine obere Schicht aus AuSn,
- eine Form (35) auf die zu bedruckende Oberfläche angewendet wird,
- die Form (35) abgenommen wird.

**10.** Verfahren nach Anspruch 6, welches weiterhin einen Schritt des Ätzens nach dem Schritt des Aufbringens der oberen Schicht umfasst.

P

11

16 14 13

15 12

16

# FIG. 1A

14 17

16

12

# FIG. 1B

20

22  23

## FIG. 2A

22

20

23

## FIG. 2B

31

30

## FIG. 3

P

35

34

31

31

30

32

36                                          36

# FIG. 4A

34

36                                          30    36

32

# FIG. 4B

31

36                                          30    36

32

# FIG. 4C

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5772905 A

- US 6179198 B

**Littérature non-brevet citée dans la description**

- **S. W. PANG ; T. TAMAMURA ; M. NAKAO ; A. OZAWA ; H. MASUDA.** Direct nano-printing on Al substrate using a SiC mold. *J. Vac. Sci. Technol,* Mai 1998, vol. B 16 (3), 1145, 1146